# EUROPEAN PATENT SPECIFICATION

(11) **EP 1 345 182 B1**
(45) Date of publication and mention of the grant of the patent: **26.09.2007**
(21) Application number: 03005050.4
(22) Date of filing: 06.03.2003
(51) Int. Cl.: G07C 5/08

(54) **Vehicle data system**
System für Fahrzeugdaten
Système de données de véhicule

(30) Priority: 15.03.2002 GB 0206113
(43) Date of publication of application: 17.09.2003
(73) Proprietor: HALDEX BRAKE PRODUCTS LIMITED, Redditch Worcestershire B98 9HA (GB)
(72) Inventor: Bale, Paul, Russell, Worcestershire WR5 3PF (GB); Sayce-Jones, Robin, Worcestershire B60 1DF (GB)
(74) Representative: Lockey, Robert Alexander

(56) References cited:
- EP-A- 1 059 508
- DE-A- 10 029 401
- US-A- 4 542 461
- US-A- 4 757 454
- US-A- 5 781 871

## Description

This invention relates to a vehicle data system.

To enable sufficient monitoring and maintenance of vehicles, particularly goods vehicles, it is desirable that data values relating to parameters of the vehicle performance and operation are stored and made available to maintenance personnel or other personnel as desired. Such monitoring may help identify when a vehicle is likely to need servicing or maintenance, or when a vehicle part should be replaced, or indeed when a vehicle has been incorrectly used. It is desirable that the parameter values are stored, transmitted to appropriate devices and made available to maintenance personnel as easily and reliably as possible. It will of course be apparent that where values corresponding to a number of parameters are stored over a long period of time, a potentially large amount of data may be required to be stored.

It is known from US 5781871, US 4757454 and EP 1059508 A to record data values for a vehicle in a control unit on the vehicle and from US 4757454 and EP 1059508 A to aggregate the captured data into histogram count values.

An aim of the invention is to provide a new or improved vehicle data system.

According to the invention, a vehicle data system as defined by claim 1 is provided.

The invention will now be described by way of example only with reference to the accompanying drawings, wherein:-
Figure 1 is a diagrammatic illustration of a vehicle data system,
Figure 2 is a diagrammatic illustration of a histogram stored by the system of Figure 1,
Figure 3 is an illustration of a message structure for use in the vehicle data system of Figure 1, and
Figure 4 is a diagrammatic illustration of a remote access system.

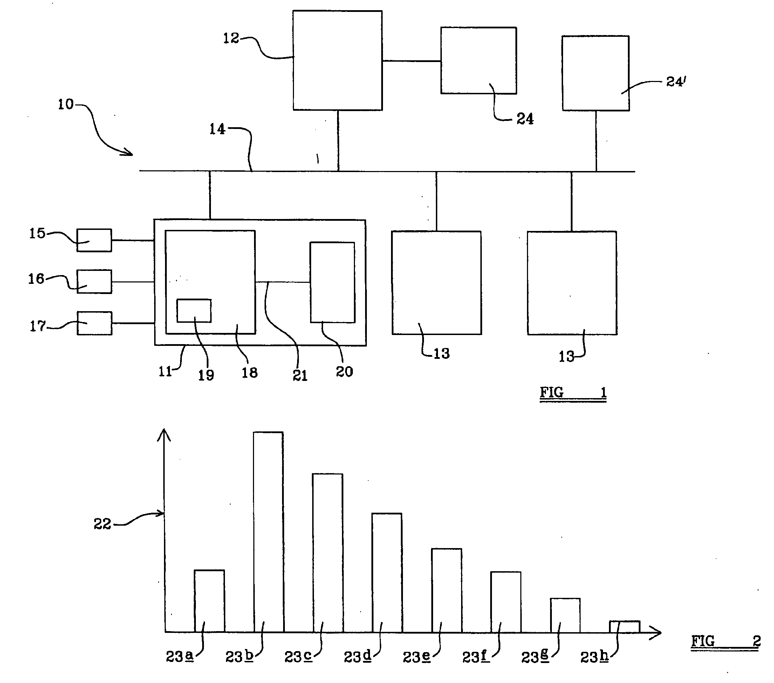

Referring now to Figure 1, a vehicle data system is generally illustrated at 10 comprising an electronic control unit (ECU) 11, a data logger 12, and a plurality of further devices 13. The ECU 11, logger 12 and further devices 13 are each connected to an appropriate data bus 14, in the present example comprising a CANBus although any appropriate bus and message protocol may be used as desired. The ECU 11, logger 12 and other devices 13 transmit and/or receive appropriate messages via the bus 14 comprising data or instructions or any other content as desired.

The ECU 11 is connected to a desired plurality of sensors, in the present example three sensors 15, 16, 17, which are operable to supply data values corresponding to selected parameters to the ECU 11. For example, sensors 15 and 16 may comprise wheel speed sensors and sensor 17 may comprise a brake pressure sensor. It will further be apparent that one or more of the further devices 13 may comprise a sensor operable to transmit data values to the ECU 11 via the bus 14. The ECU 1 comprises a controller 18, in this example a RISC microcontroller, provided with an on-board random access memory (RAM) 19, and a non-volatile memory 20, in the present example comprising an EEPROM. The controller 18 and non-volatile memory 20 are connected by a suitable bus 21, for example an I²C bus. The ECU is also connected to a power supply (not shown) and is responsive to and able to detect the supply voltage of the power supply.

The ECU 11 is operable to receive data values from sensors 15, 16, 17 and any other sensors where provided over an extended period of time. It will be apparent that a large number of data values will be generated; in the example of wheel speed sensors, a data value corresponding to a wheel speed in the present example is generated every ten milliseconds.

To overcome the problem of providing sufficient memory to store the data values, the ECU generates a histogram for each parameter. First, an array of histograms comprising a histogram for each parameter which it is desired to monitor is defined by the controller 18. A plurality of ranges are defined for each histogram. In the present example, each histogram comprises eight ranges. The histogram array comprising a count value corresponding to each range of each histogram is stored in the non-volatile memory 20.

On initialisation, the controller 18 will download the stored histogram array from the non-volatile memory 20 into the on-board RAM 19. If the histograms array has been cleared, after first initialisation, the count value for each range of each histogram will be zero. As data values are received from the sensors 15, 16, 17, the controller 18 will determine the parameter to which each value corresponds, and then identify the range in the histogram relating to that parameter in which the data value falls. The count value for that range will then be incremented by one. Where the data value is received from a sensor 15, 16, 17, it will be apparent to which parameter the value relates. If the data value is received from a further device 13 via the bus 14 then the message transmitted by the further device 13 may identify the sending device and/or the parameter, and the controller 18 will be able to read the message and select the appropriate histogram and range to be incremented.

The data values are received by the ECU 11 according to a selected regime. In one regime, a plurality of data values may be received at regular intervals and the count values of the appropriate ranges of the corresponding histogram updated regularly.

In an alternate regime, the data values are gated such that a plurality of data values are received periodically and the corresponding count values incremented only when a gate condition is met. In a yet further regime, one or more values may be received and the corresponding count value incremented in response to the occurrence of a predetermined event. For example, where the value received relates to operation of a brake apply valve, the stored value may be the highest value for brake pressure supplied.

It is desirable that the histogram array stored in the non-volatile memory 20 is updated, by transferring the data from the on-board RAM 19 to the non-volatile memory 20. The transfer may be performed periodically or in response to an event. For example, when no event is detected, the data from the RAM 20 may be stored in the non-volatile memory 20 every two minutes or at other time intervals as appropriate. The ECU 11 may receive data values from a sensor comprising a vehicle odometer indicating the distance travelled, and the histogram count values may be transferred when a predefined distance has been reached, for example every ten kilometres. Other events may be defined, such as power off, or such as a brake application; the histogram array may for example be transferred every ten brake applications. It will be apparent that the transfer may be performed in response to any other criterion or event as desired. It will further be apparent that the stored count values for each range of each histogram need not be stored in the non-volatile memory 20 at every storage event. For example, where the stored counts values are stored in the non-volatile memory 20 in response to a certain distance having elapsed, and no brake applications have occurred, then only the distance travelled histogram count values need be stored.

The histogram array stored in the non-volatile memory 20 may be output as desired. For example, a diagnostic request may be received from a suitable diagnostic system via the bus 14, for example Keyword Protocol 2000. Alternatively, the stored data may be transmitted to the logger 12 via the bus 14 in response to a suitable criterion, for example an elapsed distance travelled or time elapsed since last update.

In the present example, the ECU 11 comprises an ABS controller, and will thus receive values corresponding to the parameters of brake demand pressure, supplied brake pressure, wheel speed and vehicle speed, and brake solenoid operation. In this example, the types of parameters which may be stored are set out as shown below, with example times, although the parameters and times only be varied as desired.

### Brake Demand Vs Time

On power up the stored histogram array data is loaded to the RAM 19 from the non-volatile memory 20.

Every 10 milliseconds the current brake demand data value is analysed and the corresponding count value updated.

Every 20 seconds the histogram is stored in the non-volatile memory 20.

The histogram will thus show the time spent at the various levels of pressure.

### Pressure Delivery Vs Time

On power up the stored histogram array is loaded from the non-volatile memory 20.

Every 10 milliseconds the current pressure delivered data value is analysed and the corresponding count value updated.

Every 20 seconds the histogram is stored in the non-volatile memory 20.

The histogram will thus show the time spent at the various levels of pressure.

### Vehicle Speed Vs Time

On power up the stored speed histogram is loaded from the non-volatile memory 20.

Every 10 milliseconds the current data value for the vehicle speed parameter is analysed and the corresponding count value incremented.

Every 2.5km the histogram is stored in the non-volatile memory 20.

The histogram will thus show the time spent by the vehicle in each speed range.

### Peak Demand Pressure Per Brake Apply cycle histogram

On power up the stored peak demand histogram is loaded from the non-volatile memory 20.

Every time brake application is performed a peak pressure demand is cleared.

Every 10 milliseconds the demand pressure is analysed and its maximum value for this brake apply cycle stored.

When the brake application ceases the peak demand pressure data valve is analysed and the corresponding count value incremented.

Every 10 brake applications the histogram is stored to the non-volatile memory 20.

This data would show the variation of brake applications the vehicle experiences.

### Solenoid Operations

On power up the solenoid operation histogram is loaded from the non-volatile memory 20.

Every 10 milliseconds the state of the or each solenoid is analysed and a change of state.

Every 10 brake applications the solenoid operation histogram is stored.

Further histograms can be stored depending on the application and the parameters it is required to monitor.

The stored histogram array may be downloaded into a suitable processing system, for example a PC, which can then read the stored histogram array and convert it into normalised data. It will be apparent that the processing system will need to know the parameter to which each histogram relates, and the values to which each range of each histogram relates. An example of downloaded raw data is set out below in table form. Raw Data

| Tue | May | | 15 | 10.51:33 am 2001 | | | | | | | | | |
|---|---|---|---|---|---|---|---|---|---|---|---|---|---|
| dec | timestamps | absolute | | | | | | | | | | | |
| internal | events | logged | | | | | | | | | | | |
| 565.5783 | | 209715232x | Rx | d | 8 | 32 | 0 | 0 | 0 | 0 | 100 | 0 | 26 |
| 565.5882 | | 209715232x | Rx | d | 8 | 32 | 1 | 0 | 0 | 25 | 137 | 112 | 86 |
| 565.5982 | | 209715232x | Rx | d | 8 | 32 | 1 | 1 | 0 | 1 | 66 | 102 | 172 |
| 565.6082 | | 209715232x | Rx | d | 8 | 32 | 1 | 2 | 0 | 0 | 64 | 27 | 183 |
| 565.6182 | | 209715232x | Rx | d | 8 | 32 | 1 | 3 | 0 | 0 | 10 | 123 | 65 |
| 565.6283 | | 209715232x | Rx | d | 8 | 32 | 1 | 4 | 0 | 0 | 3 | 69 | 139 |
| 565.6383 | | 209715232x | Rx | d | 8 | 32 | 1 | 5 | 0 | 0 | 5 | 181 | 144 |
| 565.6483 | | 209715232x | Rx | d | 8 | 32 | 1 | 6 | 0 | 0 | 44 | 136 | 192 |
| 565.6582 | | 209715232x | Rx | d | 8 | 32 | 1 | 7 | 0 | 1 | 207 | 181 | 173 |
| 565/6682 | | 209715232x | Rx | d | 8 | 32 | 2 | 0 | 0 | 5 | 219 | 113 | 25 |
| 565.6782 | | 20971S232x | Rx | d | 8 | 32 | 2 | 1 | 0 | 1 | 14 | 175 | 158 |
| 565.6882 | | 209715232x | Rx | d | 8 | 32 | 2 | 2 | 0 | 1 | 48 | 201 | 153 |

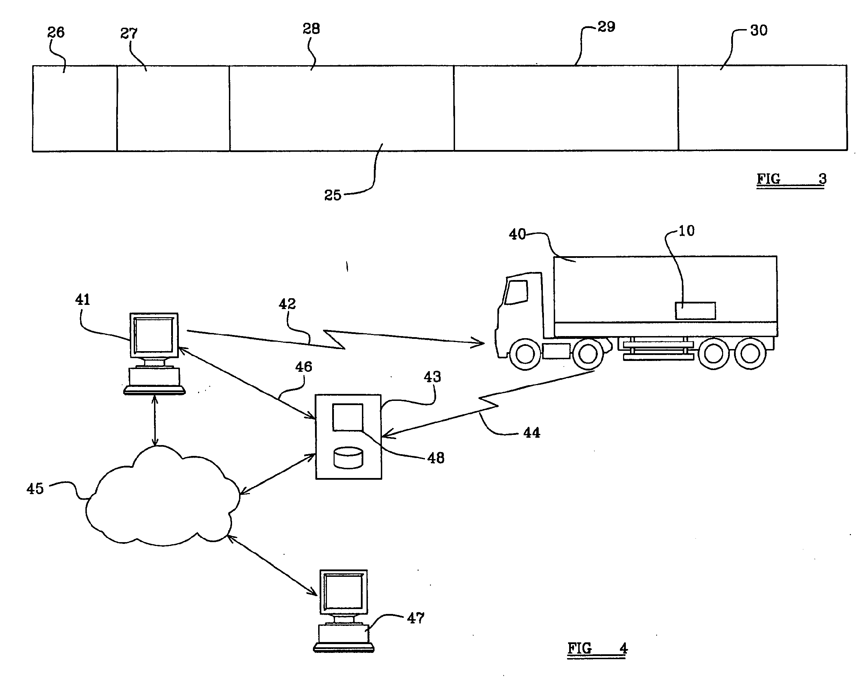

The first column is a timestamp generated by the receiving system. The next two columns show which bus has been used, in this example the CANBus identifier number. Rx indicates that this is a received message and d that the numbers are stored in decimal form. The number 8 indicates the number of bytes in the message, and the number 32 in the next column indicates that this is an event message. The next column indicates the parameter, so in this example 0 indicates that the value is an odometer reading, 1 indicates that the value is a brake pressure demand value, 2 indicates that the value is a vehicle speed value and so forth. This digit effectively indicates the histogram to which the count value relates. The next data shows the range of the histogram, and the last four columns represent a 32 bit number encoding the count value for that range of the histogram. The data can be appropriately processed and a histogram such as to that shown in Figure 2 at 22 can be generated, having count values corresponding to the ranges 23a to 23h.

In the present example, a histogram array comprising 6 histograms each having eight ranges characterised by a 32 bit number is provided, requiring 192 bytes of memory. Since the count values are stored as 32 bit numbers, where a parameter is monitored every 10 milliseconds, then if every count is stored in the same histogram range, this gives a period of 497 days before the count value for that range rolls over. In practice, the received data values will result in the count values for different ranges of the histogram being incremented and so it can be expected that in practice at least two years of data may be stored in this manner. Since it is expected that a vehicle will be serviced and maintained annually, in principle the count values should not roll over between servicings. When the vehicle is serviced and the stored histogram array downloaded, the stored count values are preferably reset to zero.

It is preferable to update the stored values in the on-board RAM 19 and only update the non-volatile memory 20 periodically since writing to the non-volatile memory 20 takes substantially longer than writing to the on-board RAM 19. Where the non-volatile memory comprises an EEPROM as in this example, the lifetime of the EEPROM is such that the memory can only be written to for a limited number of times before failure. Thus, by storing the count values in RAM and periodically updating the non-volatile memory 20, the time taken to update the histogram on receipt of a data value is shortened and the number of write events to the non-volatile memory 20 are reduced, thus potentially extending the working life of the non-volatile memory 20.

It will be apparent that any appropriate memory type and size may be provided as desired depending on the numbers and ranges of the values which it is desired to store.

In the present example, the logger 12 comprises a data logger of generally known type, connected to an external output module 24, for example a cellular radio telephone modem. The logger 12 is operable to store data received via the bus 14 from the ECU 11, or from a further device 13, or to receive data directly from a sensor connected to the logger 12. The logger may also be responsive to event messages to log selected data as required.

The ECU 11 in the present example is operable to generate an event message which is transmitted via the bus 14 to the logger 12, although such events may be generated by any suitable ECU or further device 13 as desired. Preferably the logger 12 is operable to continually maintain a store of the most recent data values received by the logger, for example the most recent 20 seconds. On receiving an event message, the logger 12 retains the most recent data values, for example those logged in a desired time period preceding the event message, discarding the remainder and then logs data values relating to one or more selected parameters for any preset period or until a stop event message is received. The desired period may be a fixed period, such as five seconds, or may be variable in accordance with, for example, the amount of data to be stored or according to trigger event conditions. The stored data may then be transmitted via the output module 24 to a suitable diagnostic system or otherwise. The nature of the event which results in a start event message being transmitted to the logger 12 may be selected as desired.

In the example where the ECU 11 comprises an ABS controller, on occurrence of an ABS event, a start event message is sent to the logger 12 identifying that an ABS event has occurred. The logger 12 will retain the data values stored in the 5 seconds preceding the start event message, and then log data values relating to wheel speed and brake pressure parameters until a stop event message is generated by the ECU 11 and sent to the logger 12.

In another example, where an ECU 11 is provided with means to receive and log fault codes, a start event message may be sent to the logger 12 on receipt of such a fault code. It is known to provide devices which, on occurrence of a fault, are operable to generate fault codes or diagnostic trouble codes (DTCs). Conventionally, the ECU 11 comprises a fault occurrence counter stored in a non-volatile memory. On the first occurrence of a fault, the fault code, odometer reading and other data values are stored and on subsequent occurrence of the fault, a counter indicating the number of occurrences of that fault is incremented. Where the ECU 11 is operable to distinguish between new faults and the recurrence of old faults, preferably a start event message is generated only on the occurrence of a new fault. Otherwise, it might be expected that where a recurrent fault exists, the logger 12 may be filled by repeatedly storing data in response to the recurring fault. However, where an old fault code is detected within two seconds of power up, in the present example the ECU 11 reacts as to a new fault code and will generate a start event message as described hereinbefore.

In a third example, where the ECU 11 is operable to store a histogram array as discussed hereinbefore, the ECU 11 may be operable to transmit the stored histogram array to the logger 12 in response to an event as discussed hereinbefore. The ECU 11 generates a start event message identifying the event as a histogram event, and then transmits the stored count values to the logger 12, followed by a stop event message. The histogram data may then be easily downloaded from the logger 12 via the output module 24, without the necessity for connecting a device to the bus 14.

To ensure that messages transmitted on the bus 14 are received by the appropriate receiving device, a suitable message protocol may be used. Conventionally, in accordance with the CAN 2.0B specification, 29 bits (binary digits) are made available for providing address information for a message generally illustrated at 25 in Figure 3. In the present invention, the 29 bits of the address information 25 are allocated as follows. The first three bits 26 contain a priority identifier. The next four bits 27 identify the message type. For example 0001 may correspond to GPS information, 0010 may correspond to instrumentation information, 0011 to GSM information, 0100 to TCP/IP information and so on. It will be apparent that up to sixteen different message types may be identified in this part of the message. The next 8-bit block 28 comprises a source byte operable to identify the ECU or other device generating a message. This value is common for all ECU's or other devices of the same type and it will be apparent that there are up to 256 possible values. The next 8-bit block 29 comprises a target byte identifies the target ECU or device. Normally, this byte would be set to the same value as the source byte 28 of the ECU to which the message is intended to be sent. However, where multiple ECUs or other devices of the same type are provided on the CANBus, the target byte of each identical ECU or device may be preset as a non-volatile parameter or dynamically allocated on power up of the system 10 or otherwise be a combination of stored and dynamically allocated values, such that each identical ECU or device is identified by a different target byte.

The final block 30 of six bits comprises a message space and may be used as appropriate for each device. For example, for a diagnostic request, these bits can be set to identify whether the message comprises a diagnostic request or a diagnostic response. Where the message comprises a part of a multi-page message, the message part can be identified. Alternatively, where a short message is required to be sent, for example a start event message as described hereinbefore, the relevant information may be encoded in the six bit block 30. It will be apparent that such addressing protocol may be used in any appropriate system as desired, and not merely within the system of Figure 1.

Where the vehicle data system 10 comprises a communication module 24 enabling remote access to the logger 12, it is advantageous to provide remote access to the stored histogram array or the stored data. Further or alternatively, an output module 24' may be provided connected to the bus 14 in appropriate manner, in which case it will be possible to establish a diagnostic session with the vehicle data system 10 as shown in Figure 4. Referring to Figure 4, a vehicle 40 is shown provided with a vehicle data system 10 similar to that shown in Figure 1. A user device 41 is operable to transmit and receive information from the output module 24, 24' via a remote connector 42. A vehicle data server is shown at 43, similarly operable to establish a two way connection with the vehicle data system 10 as shown via a remote connection 44 and provided with a data store 48 to receive a stored histogram array or other stored data. The vehicle data server 43 may be accessible via the Internet 45 or via a suitable modem connection generally indicated at 46. It might be envisaged that a user device such as that shown at 47 will only be able to obtain the stored histogram array or other stored data from the vehicle data server 43, possibly via the Internet 45, and will not be able to establish direct communication with the vehicle data system 10. Alternatively, the system 41 may be operable only to transmit a request to the vehicle data system 10 that it transmit the stored vehicle data to the vehicle data server 43 so that the vehicle data server 43 is supplied with the current stored histogram array or other stored data.

Advantageously the vehicle data server 43 comprises a subscriber information store 49, such that only user systems which comprise or belong to subscribers can access the data store 48. The user devices 41, 47 may display the vehicle data as desired, for example as a simulated conventional diagnostic system or otherwise. Where a two-way communication link is established between the user device 47, vehicle data server 43 and vehicle data system 10, a suitable diagnostic session may be performed in conventional manner.

Such a system will, for example, enable a fleet management organisation to monitor the parameters of vehicles in the fleet remotely without needing to recall the vehicles to a control service point or otherwise gain physical access to the vehicle.

## Claims

1. A vehicle data system (10) comprising a control unit (11) and a data logger (12), the control unit (11) being operable to store vehicle data relating to a parameter by performing the steps of :
defining a histogram (22) comprising a plurality of ranges (23a, 23b, 23c, 23d, 23e, 23f, 23g, 23h) having an associated count value;
receiving a plurality of data values corresponding to said parameter from a sensor (15, 16, 17); and
identifying a range (23a, 23b, 23c, 23d, 23e, 23f 23g, 23h) corresponding to each data value, and incrementing the count value associated with the identified range (23a, 23b 23c, 23d, 23e, 23f, 23g, 23h);
**characterised in that**;
the vehicle data system (10) further comprises a bus (14);
the control unit (11) and data logger (12) are connected to the bus (14);
the control unit (11) is further operable to generate an event message in response to an event and transmit the event message to the data logger (12) via the bus (14);
the data logger (12) is operable to receive and store data in response to the event message; and
the control unit (11) is operable to transmit the count values to the logger (12) via the bus.

2. A vehicle data system (10) according to claim 1 wherein the control unit (11) is operable to defining a histogram array comprising a plurality of histograms (22) each corresponding to a selected parameter.

3. A vehicle data system (10) according to claim 1 or claim 2 operable to store the count values in a non-volatile storage medium (20).

4. A vehicle data system (10) according to claim 3, wherein the control unit (11) has a volatile memory (19), and a non-volatile memory (20).

5. A vehicle data system (10) according to claim 4 wherein the control unit is operable to transfer the count values from the non-volatile memory (20) to the volatile memory (19), update the count values in the volatile memory and transfer the count values to the non-volatile memory (19).

6. A vehicle data system (10) according to any one of the preceding claims 6 comprising at least one sensor (15, 16, 17) operable to supply data values corresponding to the parameter to the control unit (11).

7. A vehicle data system (10) according to any one of the preceding claims wherein the control unit (11) is operable to generate a stop message and transmit the stop message to the data logger (12)

8. A vehicle data system (10) according to any one of the preceding claims wherein the control unit (11) is operable to transmit data to the logger (12) via the bus (14).

9. A vehicle data system (10) according to any one of the preceding claims wherein the data logger (12) is operable, on receipt of an event message, to store data received prior to the event message.

10. A vehicle data system (10) according to any one of the preceding claims comprising an output module (24, 24') which is connected to one of the data logger and the bus.

## Patentansprüche

1. Fahrzeugdatensystem (10) umfassend eine Steuereinheit (11) und ein Datenaufzeichnungsgerät (12), wobei die Steuereinheit (11) betriebsfähig ist, um Fahrzeugdaten betreffend einen Parameter zu speichern, indem die folgenden Schritte durchgeführt werden:
Definieren eines Histogramms (22), das eine Vielzahl von Bereichen (23a, 23b, 23c, 23d, 23e, 23f, 23g, 23h) mit einem damit verbundenen Zählwert umfasst;
Empfangen einer Vielzahl von Datenwerten von einem Messfühler (15, 16, 17), die dem Parameter entsprechen; und
Identifizieren eines Bereiches (23a, 23b, 23c, 23d, 23e, 23f, 23g, 23h), der einem jeden Datenwert entspricht, und Inkrementieren des Zählwertes, der mit dem identifizierten Bereich (23a, 23b, 23c, 23d, 23e, 23f, 23g, 23h) verbunden ist;
**dadurch gekennzeichnet, dass**
das Fahrzeugdatensystem (10) weiter einen Bus (14) umfasst;
die Steuereinheit (11) und das Datenaufzeichnungsgerät (12) mit dem Bus (14) verbunden sind;
die Steuereinheit (11) weiter betriebsfähig ist, um eine Ereignisnachricht in Reaktion auf ein Ereignis zu erzeugen und die Ereignisnachricht an das Datenaufzeichnungsgerät (12) vermittels des Busses (14) zu übertragen;
das Datenaufzeichnungsgerät (12) betriebsfähig ist, um Daten in Reaktion auf die Ereignisnachricht zu empfangen und zu speichern; und
die Steuereinheit (11) betriebsfähig ist, um die Zählwerte an das Datenaufzeichnungsgerät (12) vermittels des Busses zu übertragen.

2. Fahrzeugdatensystem (10) gemäß Anspruch 1, wobei die Steuereinheit (11) betriebsfähig ist, um eine Histogrammmatrix zu definieren, die eine Vielzahl von Histogrammen (22) umfasst, wobei ein jedes einem ausgewählten Parameter entspricht.

3. Fahrzeugdatensystem (10) gemäß Anspruch 1 oder Anspruch 2, betriebsfähig, um die Zählwerte in einem nicht-flüchtigen Speichermedium (20) zu speichern.

4. Fahrzeugdatensystem (10) gemäß Anspruch 3, wobei die Steuereinheit (11) einen flüchtigen Speicher (19) und einen nicht-flüchtigen Speicher (20) umfasst.

5. Fahrzeugdatensystem (10) gemäß Anspruch 4, wobei die Steuereinheit betriebsfähig ist, um die Zählwerte aus dem nicht-flüchtigen Speicher (20) in den flüchtigen Speicher (19) zu überführen, die Zählwerte in dem flüchtigen Speicher zu aktualisieren und die Datenwerte in den nicht-flüchtigen Speicher (19) zu überführen.

6. Fahrzeugdatensystem (10) gemäß einem der vorangehenden Ansprüche, umfassend wenigstens einen Messfühler (15, 16, 17), der betriebsfähig ist, um die Steuereinheit (11) mit Datenwerten, die dem Parameter entsprechen, zu versorgen.

7. Fahrzeugdatensystem (10) gemäß einem der vorangehenden Ansprüche, wobei die Steuereinheit (11) betriebsfähig ist, um eine Sperrnachricht zu erzeugen und die Sperrnachricht an das Datenaufzeichnungsgerät (12) zu übertragen.

8. Fahrzeugdatensystem (10) gemäß einem der vorangehenden Ansprüche, wobei die Steuereinheit (11) betriebsfähig ist, um vermittels des Busses (14) Daten an das Datenaufzeichnungsgerät (12) zu übertragen.

9. Fahrzeugdatensystem (10) gemäß einem der vorangehenden Ansprüche, wobei das Datenaufzeichnungsgerät (12) betriebsfähig ist, um, nach Erhalt einer Ereignisnachricht, Daten zu speichern, die vor der Ereignisnachricht empfangen wurden.

10. Fahrzeugdatensystem (10) gemäß einem der vorangehenden Ansprüche, umfassend ein Ausgabemodul (24, 24'), das mit entweder dem Datenaufzeichnungsgerät oder dem Bus verbunden ist.

## Revendications

1. Système de données pour véhicule (10) comportant une unité de commande (11) et un enregistreur automatique de données (12), l'unité de commande (11) étant opérationnelle pour mémoriser des données de véhicule concernant un paramètre en effectuant les étapes consistant à :
définir un histogramme (22) comportant une pluralité de distances (23a, 23b, 23c, 23d, 23e, 23f, 23g, 23h) ayant une valeur de compte associée,
recevoir une pluralité de valeurs de données correspondant audit paramètre depuis un capteur (15, 16, 17), et
identifier une distance (23a, 23b, 23c, 23d, 23e, 23f, 23g, 23h) correspondant à chaque valeur de données, et incrémenter la valeur de compte associée à la distance identifiée (23a, 23b, 23c, 23d, 23e, 23f, 23g, 23h),
**caractérisé en ce que** :
le système de données pour véhicule (10) comporte de plus un bus (14),
l'unité de commande (11) et l'enregistreur automatique de données (12) sont connectés au bus (14),
l'unité de commande (11) est de plus opérationnelle pour générer un message d'événement en réponse à un événement et transmettre le message d'événement à l'enregistreur automatique de données (12) via le bus (14),
l'enregistreur automatique de données (12) est opérationnel pour recevoir et mémoriser des données en réponse au message d'événement, et
l'unité de commande (11) est opérationnelle pour transmettre les valeurs de compte à l'enregistreur automatique (12) via le bus.

2. Système de données pour véhicule (10) selon la revendication 1, dans lequel l'unité de commande (11) est opérationnelle pour définir un série d'histogrammes comportant une pluralité d'histogrammes (22) correspondant chacun à un paramètre sélectionné.

3. Système de données pour véhicule (10) selon la revendication 1 ou la revendication 2, opérationnel pour mémoriser les valeurs de compte dans un support de mémorisation non-volatile (20).

4. Système de données pour véhicule (10) selon la revendication 3, dans lequel l'unité de commande (11) a une mémoire volatile (19), et une mémoire non-volatile (20).

5. Système de données pour véhicule (10) selon la revendication 4, dans lequel l'unité de commande est opérationnelle pour transférer des valeurs de compte depuis la mémoire non-volatile (20) dans la mémoire volatile (19), mettre à jour les valeurs de compte dans la mémoire volatile et transférer les valeurs de compte dans la mémoire non-volatile (19).

6. Système de données pour véhicule (10) selon l'une quelconque des revendications précédentes, comportant au moins un capteur (15, 16, 17) opérationnel pour délivrer des valeurs de données correspondant au paramètre dans l'unité de commande (11).

7. Système de données pour véhicule (10) selon l'une quelconque des revendications précédentes, dans lequel l'unité de commande (11) est opérationnelle pour générer un message d'arrêt et transmettre le message d'arrêt à l'enregistreur automatique de données (12).

8. Système de données pour véhicule (10) selon l'une quelconque des revendications précédentes, dans lequel l'unité de commande (11) est opérationnelle pour transmettre des données à l'enregistreur automatique (12) via le bus (14).

9. Système de données pour véhicule (10) selon l'une quelconque des revendications précédentes, dans lequel l'enregistreur automatique de données (12) est opérationnel, lors de la réception d'un message d'événement, pour mémoriser des données reçues avant le message d'événement.

10. Système de données pour véhicule (10) selon l'une quelconque des revendications précédentes, comportant un module de sortie (24, 24') qui est connecté à l'un parmi l'enregistreur automatique de données et le bus.
